# EUROPEAN PATENT SPECIFICATION

(11) **EP 3 608 721 B1**
(45) Date of publication and mention of the grant of the patent: **30.06.2021**
(21) Application number: 19200344.0
(22) Date of filing: 15.12.2015
(51) Int. Cl.: G03F 7/20

(54) **DIGITAL MASK PANEL FOR MAKING A FLEXOGRAPHIC PRINT MASTER**
DIGITALES MASKENPANEL ZUR HERSTELLUNG EINES FLEXODRUCKMASTERS
MASQUE DIGITAL POUR LA FABRICATION D'UN MODÈLE D'IMPRESSION FLEXOGRAPHIQUE

(43) Date of publication of application: 12.02.2020
(62) Divisional of application: 15200040.2
(73) Proprietor: AGFA NV, 2640 Mortsel (BE)
(72) Inventor: VAN DORPE, Jurgen, 2640 Mortsel (BE); MEURIS, Werner, 2640 Mortsel (BE)
(74) Representative: Strijckers, Hans Louis P.

(56) References cited:
- GB-A- 2 217 862
- US-A1- 2003 214 611
- HAYASHI T ET AL: "Photolithography system with liquid crystal display as active gray-tone mask for 3D structuring of photoresist", SENSORS AND ACTUATORS A, ELSEVIER SEQUOIA S.A., LAUSANNE, CH, vol. 144, no. 2, 15 June 2008 (2008-06-15) , pages 381-388, XP022664319, ISSN: 0924-4247, DOI: 10.1016/J.SNA.2008.02.014 [retrieved on 2008-03-07]

## Description

### Technical Field

The invention relates to a digital mask panel that is suitable for exposing a print master precursor such as a relief print master precursor.

### Background Art

### Flexographic printing

In flexographic printing a flexible cylindrical relief print master is used for transferring a fast drying ink from an anilox roller to a printable substrate. The print master can be a flexible plate that is mounted on a cylinder or it can be a cylindrical sleeve.

Because the flexographic print master has elastic properties, the process is particularly suitable for printing on a wide range of printable substrates including for example corrugated fiberboard, plastic films or even metal sheets.

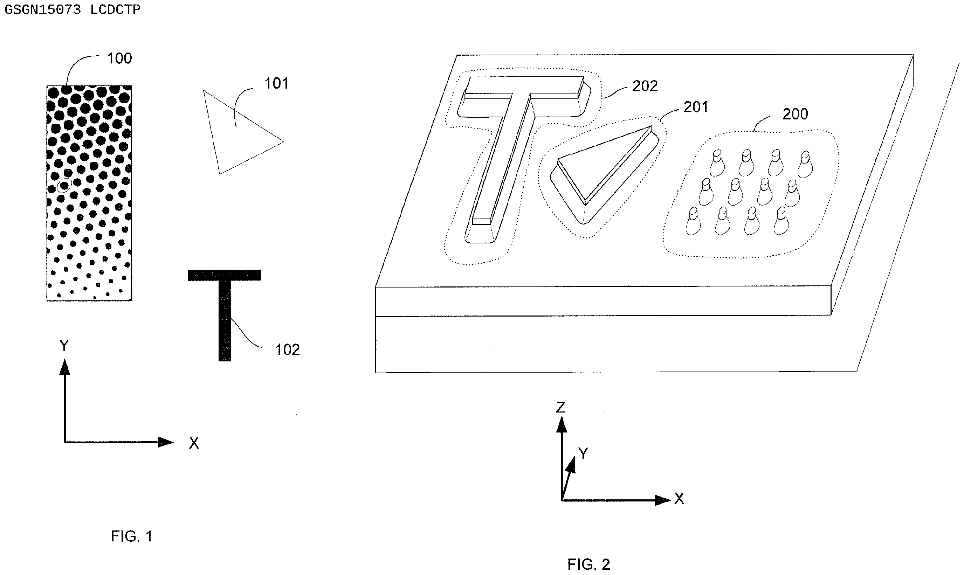

The raised portions (200, 201, 202) of the relief print master in FIG. 2 define the image features (100, 101, 102) in FIG. 1 that are to be printed.

Examples of a flexographic print master precursor are found in the range of Cyrel® EASY plate systems, manufactured and marketed by the company DuPont™.

A range of equipment that was designed to expose these Cyrel® plates is manufactured and marketed by the company Esko and is called the "CDI Spark" series ("CDI" stands for "Cyrel Digital Imager").

The negative film through which a print master precursor is exposed can be obtained in different ways.

A first method is to expose a photographic film by means of a CtF ("Computer to Film") exposing unit in response to a printable digital file that is delivered by a RIP (Raster Image Processor). After development in a hydroquinone- and metol-based developer and fixation in an acidic solution, a suitable film is obtained.

An alternative technique uses LAM (Laser Ablation Mask) as a dry patterning process in which a high energy beam of light from an excimer laser is used to directly pattern a suitable material and to obtain a mask. An advantage of this method is that no additional development and fixing step are required.

A traditional method for making a flexographic print master starts from negative film that defines the image features and that is laid upon a sheet of photopolymerizable material. The sheet is exposed by means of a UV light source through the negative film which acts like a mask.

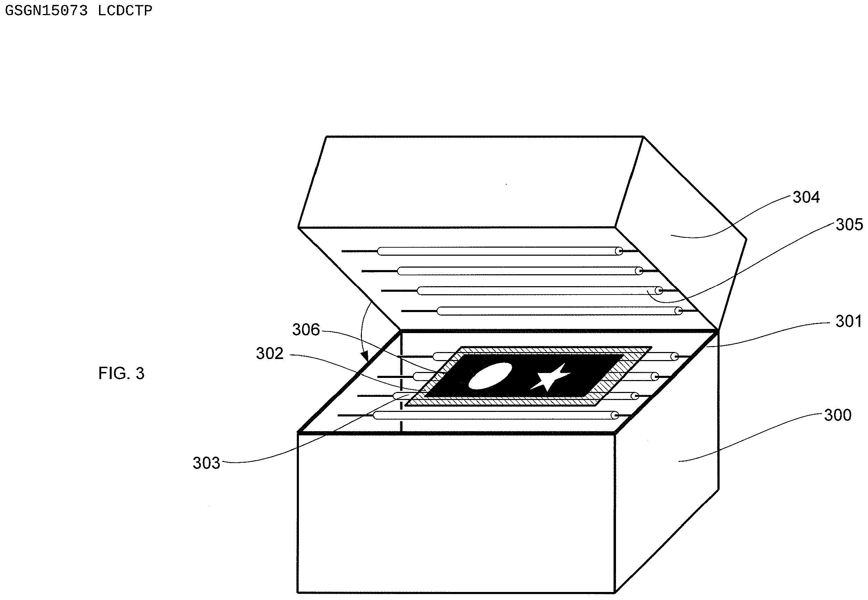

FIG. 3 shows a light box (300) that can be used for the purpose of creating a flexographic print master. A flexographic print master precursor 302 rests on a transparent plate in a frame (301). Below the frame is resides a first UV light source comprising fluorescent light bulbs (303). In a lid (304) that is connected with hinges to the light box resides a second UV light source comprising fluorescent light bulbs (305). On top of the flexographic print master precursor lies a negative film (306) with the image features.

The operation is as follows. During an exposure the lid 304 is always closed.

In a first step ("back exposure") the back of the printing plate precursor (302) is exposed by the UV-A light source 303. The effect of this exposure is that the photopolymerization in the printing plate precursor is initiated. This reduces the threshold for further polymerization during subsequent exposure steps and hence raises the photosensitivity of the precursor.

In a second step ("main exposure") the plate precursor 302 is exposed through the negative film mask (306) by the UV-A light source (305) in the lid 304. The effect of this is that the portions of the polymerizable sheet underneath the transparent parts of the film selectively polymerize under influence of the UV-A light, whereas the portions under the opaque parts of the film remain soluble. This generates the latent relief image required for the printing process.

A third step ("wash-out") includes washing out the non-polymerized monomer by means of a brush and a wash-out solution. The wash-out is followed by a "drying step" so that the wash-out solution that was absorbed by the precursor can evaporate.

A fourth step ("finishing step" or "detacking step") consists of curing the surface of the precursor by means of a short time exposure with a UV-C light source. This stabilizes the physical and chemical properties of the surface of the precursor.

A fifth and a last step ("final exposure") includes curing the precursor with UV-A light source. This final exposure ensures that all remaining monomers in the precursor are cross-linked. It also determines the final physical characteristics such as hardness of the resulting flexographic print master.

### Three-dimensional printing for making a relief print master

A three-dimensional printing technique for forming a flexographic print master is disclosed in EP 1428666 B (AGFA GRAPHICS NV) 11/12/2002. According to this method an inkjet printing system is used for jetting on a substrate at least two image-wise layers of a polymerizable fluid. After a first layer has been jetted, it is immobilized ("cured") before the subsequent layer is applied. The immobilisation is achieved with UV-light. Because according to this method the flexographic printing master is build up layer by layer, it is at least theoretically possible to control the slope of the image features in a different way for positive or for negative image features using image processing. Small positive features could receive a soft slope, whereas small negative features on the contrary could receive a steep slope. One of the problems with the above method, however, is that it is difficult to control the exact shape and thickness of the layers that are formed by jetting UV-curable ink droplets with a print head. This is related to a variety of factors such as surface tension effects and the round (as opposed to "cubic") shape of the droplets when they land onto the printable surface. These effects tend to accumulate layer by layer and the result is that the top layer of the image features does not lie in a perfect plane as would be ideal for a flexographic print master. Having not all the top layers in the same plane causes uneven pressure between the print master and the printable substrate on the rotary press, resulting in uneven transfer of the ink and serious degradation of the quality of the printed image.

Another method is disclosed in EP 2199066 B (AGFA GRAPHICS NV) 19/12/2008. According to this publication multiple layers of a flexographic print master on a drum are simultaneously created during a single cycle by different nozzles of the same print head. The advantage over the previous method is that the result is a print sleeve that is directly suitable for mounting on a rotary printing press and that print masters can be created that are 360° seamless. However, given that the print master is build up using a similar additive process of jetting UV-curable ink droplets to form additive layers as in the previous publication, the method suffers from the same deficiency that the top layers do not lie in a perfect cylindrical plane.

### Digital exposure systems

US 5049901 B (CREO PRODUCTS INC) 2/07/1990 introduces the use of a two-dimensional array of digital micro-mirrors for the purpose of exposing a print plate precursor. An imaging unit comprises a light source such as an arc lamp and a collimation lens in combination with a two-dimensional array of digital micro-mirrors and a projection lens. The imaging unit moves in a linear fashion relative to a light-sensitive printing plate precursor and exposes its surface in response to the pixels of a binary bitmap that defines the image that is to be printed by the print plate. According to the invention, each location on the recording surface is exposed multiple times by distinct rows of the digital micro-mirror device while the latter scans the surface. The invention reduces the requirements for the power of the light source by taking advantage of the relatively large area of the two-dimensional digital micro-mirror device compared to the case when only a single row of micro mirrors would be used.

EP 0950212 B (FRIEDRICH LULLAU) 31/12/1996 teaches that before exposing a light-sensitive surface, a binary bitmap is first broken down along the two dimensions into a set of contiguous rectangular partial bitmaps. A partial bitmap is exposed onto a light-sensitive printing plate precursor using an imaging unit that comprises a light source and a collimation lens in combination with a two dimensional light modulator such as an LCD panel, and a projection lens. The complete image is reconstructed by moving the imaging unit stepwise over the light-sensitive surface and each time exposing the corresponding partial bitmap. Further, **"**Photolithography system with liquid crystal display as active gray-tone mask for 3D structuring of photoresist" (Authors: Terutake Hayashi, Takayuki Shibata, Takahiro Kawashima, Eiji Makino, Takashi Mineta, Toru Masuzawa) from "Sensors and Actuators A: Physical" - Volume 144, Issue 2, 15 June 2008, Pages 381-388 - Received 2 August 2007, Revised 29 January 2008, Accepted 23 February 2008, Available online 7 March 2008 discloses an active mask fabrication by using LCD lithography system is used for developing an LCD mask exposure system by using UV light source.

### Liquid crystal displays (LCD)

High resolution and large format liquid crystal displays are currently available for application in video displays. For example, a 60" video RGB display with a 16/9 aspect ratio is commercially available that has 3996× 2160 (4K resolution TV) addressable pixels and that features a frame-update frequency of 60 frames per second. The size of such a panel is approximately 130 cm by 70 cm and a single RGB pixel has a size of approximately 325 µm by 325 µm.

Given that every RGB pixel actually comprises three sub-pixels, the dimensions of a subpixel are rather 325 µm by 108 µm.

### Unresolved problems

The current technology to create a flexographic print master is still insufficient. The need to prepare a contact film in the traditional plate making process is a step that requires separate equipment and that involves additional production steps. The three-dimensional printing methods for making a relief print master solve these problems but require equipment that is complex and expensive.

### Summary of invention

The invention is disclosed in the independent claim 1 and the dependent claims.

The current invention deals with an improved system for creating a flexographic or offset print master that uses a two-dimensional transparent light valve array that is driven by a raster image processor. The array provides the equivalent of a digital contact mask, thereby eliminating the need for additional equipment to create a contact film. Since the contact mask is essentially solid-state, it is significantly less complex and expensive than systems for creating a relief print master using three-dimensional printing.

### Brief description of drawings

FIG. 1 shows a set of different image features;
FIG. 2 shows a relief print master for printing the different image features in FIG. 1;
FIG. 3 shows a light box suitable for making a relief print master;
FIG. 4 shows an exploded view of a digital mask panel according to the current invention;
FIG. 5 shows an equivalent electrical circuit for driving the pixels of a digital mask according to the current invention;
FIG. 6A and 6B show two alternative embodiments for a lay out of a transistor with regard to the pixel element that the transistor is driving.

### Description of embodiments

### The panel

The panel is a two-dimensional panel having pixels that can have two conditions of translucency. In a first condition, which is arbitrarily called an off-condition, the transparency is low and in a second condition the transparency is high.

Said panel is suitable for exposing a printing plate precursor (302), the panel comprising a two-dimensional array of pixels of which the transparency can be individually switched between a first level and a second level that is lower than the first level, the ratio of the first over the second level defining a contrast ratio;
the panel being characterized in that:
- said contrast ratio exceeds 20/1 in the UV-A (15 µm - 400 µm) part of the electromagnetic spectrum; and
- whereby the pitch of an pixel array is 40 µm or smaller.

### Basic specifications of the panel for plate making

The dimensions of the panel are preferably selected so that it easily retrofits in existing light frames. The inventors have found that a panel size of 1250 mm by 950 mm covers 80% of the light frames that are currently used in the flexographic industry and therefor is a preferred size. According to one embodiment of the invention the panel has a width in the range from 850 mm to 1050 mm and a height in the range from 1150 mm to 1350 mm.

The inventors have found that for the purpose of plate making, the pixels are preferably square and their size is preferably 40 µm by 40 µm or less. If high quality halftone images are desired the pixel size is preferably 20 µm by 20 µm or less and even more preferably 10 µm by 10 µm or less.

Such small pixel sizes are within reach of the current state of the art, especially since the specifications for other technical characteristics of the invented panel can be relaxed compared to the specifications for video displays.

The inventors have found that for the purpose of plate-making, the ratio of the second over the first transparency level ("the contrast ratio") is preferably 20/1 or higher, preferably 100/1 or higher when measured in the UV-A spectrum (315 - 400 nm).

As far as tonal resolution is concerned, one-bit monochrome tonal resolution is sufficient. Preferably the tonal resolution is 2 or even 3 bits.

The display refresh time (the time to reload a complete image) should be less than 20 seconds, preferably less than 5 seconds.

Whereas "viewing angle width" is an important characteristic in display panels, this is not at all the case for a panel in current invention. On the contrary even since a wide viewing angle promotes optical cross talk between neighboring pixels in the panel.

The lifetime of the panel is defined as the time span from new to the point in time when more than 1 out of 10.000 isolated pixels fail or when the contrast ratio of the panel gets below 20/1. A failing pixel is defined as a pixel that is permanently in the first or in the second translucency state.

During a single exposure the panel receives an amount of energy in the UV-A light spectrum (315 nm to 400 nm) equivalent to between 9 J/cm² and 18 J/cm². The panel is designed to resist this energy at least 10.000 times before an appreciable decay becomes apparent and before the contrast either locally or globally is reduced to a level of 20/1 or less.

### Panel build-up

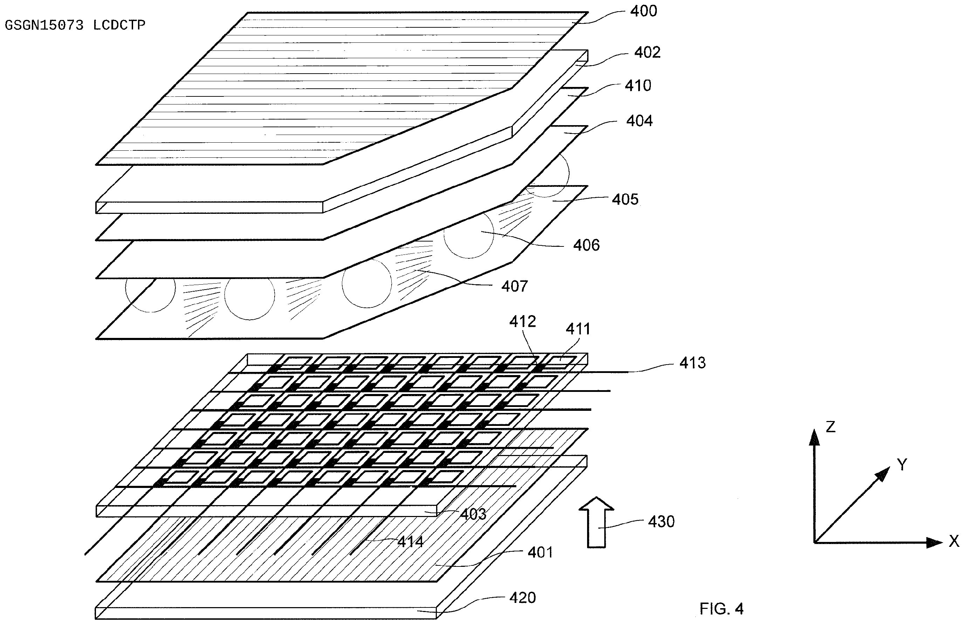

FIG. 4 shows an exploded view of an exemplary panel that is suitable for use in the current invention. Only the most essential elements are shown. The figure was not drawn at scale.

At the heart of the panel are "twisted nematic liquid crystals" (407). The optical characteristics of the molecules in such a twisted nematic liquid crystal are highly asymmetrical. They are organized around a path that is roughly parallel to the Z-dimension in a way that is similar to the steps of a helical staircase. As a result, the twisted nematic liquid crystals behave like a circular optical polarizing filter. In this particular case the twisted nematic liquid crystals are designed to turn the optical polarization of light that passes parallel to the Z axis by ninety degrees.

The twisted nematic liquid crystals reside between two polymer layers (404 and 405) that are kept at a fixed distance by multiple spacer spheres (406). The diameter of the spacer spheres is in the order of microns, for example 4 µm, preferably between 2 µm and 4 µm.

The polymer layers (404 and 405) themselves are sandwiched in between two ultra-thin glass plates (402 and 403). The thickness of the plate 403 is around 0.8 mm, preferably between 0.5 mm and 1.5 mm. The thickness of the glass plate (403) is preferably below 0.05 mm, for example 0.03 mm.

In between the glass plate (402) and the polymer foil (404) is a transparent electrode (410) which is kept at a fixed electrical potential such as for example the ground potential.

In between the glass plate 403 and the polymer foil 405 resides a matrix of transparent electrodes (411) - one per pixel. The potential of every electrode (411) is controlled by means of a thin-film field effect transistor (412). The gate of the thin film field effect transistor (412) is driven by a gate line conductor (413) and the source by a data line conductor (414). The electrode (411) in combination with the electrode 410 forms a capacitor - one per pixel that keeps its charge during a complete cycle between two updates of the pixel value.

The optical polarizing filter (400) only passes light along the Z-dimension according to a first orientation in the X-Y plane, whereas the optical polarizing filter (401) only passes light along a second dimension in the X-Y plane that is orthogonal to the first dimension.

The element (420) is a collimating micro-lens system having the same pitch as the two-dimensional pixel array and being aligned to it.

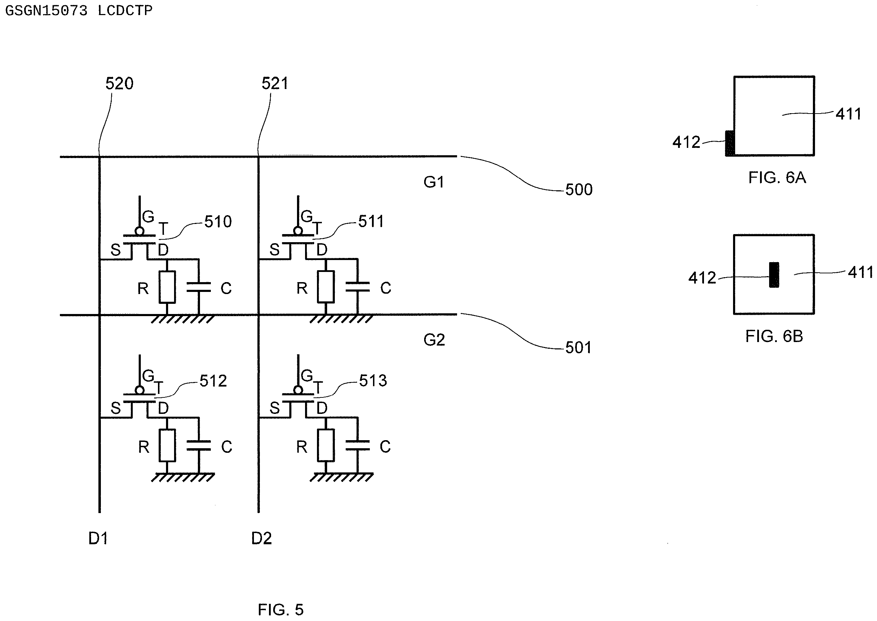

FIG. 5 shows the equivalent electric circuit of the electronics that drive a four individual pixels.

G1 and G2 are two conducts (500, 501) that are connected to the gates G of four field effect transistors T (510-513).

D1 and D2 are data lines (520, 521) to which the sources of the field effect transistors (510-513) are connected.

The drain D of every field effect transistor is connected to an electrode 411 having a capacity C with regard to the common electrode 410. The resistor R corresponds with the parallel electrical resistance that is caused by the twisted nematic liquid crystals and the field effect transistor.

### Electrical operation of the panel

The field effect transistors in FIG. 5 act like on-off switches. When the gate line conductors G1 and G2 (500, 501) are electrically grounded, the transistors (510-513) behave like open switches. The capacities C corresponding to the pixels are essentially isolated in that case from the driving circuitry and the only discharge of these capacities C is caused by the leakage current flowing through the parallel resistors R. Therefore, the voltage across the capacitors C and the electrical field between the electrodes of these capacitors remains essentially constant.

When a positive voltage is applied to one of the gate line conductors (500-501), for example to the gate line conductor 500, the transistors (510 and 511) of which the gates G are connected to the gate line conductor (500) will start conducting. In that case the capacitors C that are connected to the transistors (510-511) will be charged or discharged depending on the voltage on the data line conductors (520-521) to which the sources S of the transistors (510-511) are connected. In this way, all the capacitors C of the row of pixels that corresponds with the gate line conductor (500) can be charged or discharged to obtain a specific electrical field between the corresponding sets of their electrodes.

By repeating this process for the other rows of pixels, the electrical fields between the electrodes of all the capacitors corresponding to a pixel in the two-dimensional panel can be individually addressed.

In practice, all the gate line conductors are activated by a circular counter that addresses sequentially all the rows of pixels. For every row of pixels a multiplexer circuit selects the appropriate digital count values for every column pixel on the selected row. By means of a D/A-convertor the digital count value of every pixel on said row is converted in a corresponding voltage that is applied to the corresponding data line conductor.

### Optical operation of the panel (FIG. 4)

The collimating micro-lens system (420) converts the diffuse incoming light into a parallel beam of light rays.

When a collimated light beam along the Z-dimension passes through the optical polarizing filter (401) in the direction of the arrow (430), only that portion of the light that corresponds with the orientation of the optical polarizing filter will get through.

When the electrical field across a capacity formed by two electrodes (410 and 411) corresponding to a pixel is zero, the filtered light next passes through the twisted nematic liquid crystals (407), where its optical polarization orientation will be turned by ninety degrees because of the circular optical polarization characteristic of the twisted nematic liquid crystals.

As a result, the polarization orientation of the light when it has passed the twisted nematic liquid crystal, lines up with the orientation of the optical polarization filter (400). The net effect is that the light beam will pass through the pixel that corresponds with the electrode (411).

When the electrical field between the electrodes (410) and (411) of a pixel is not equal to zero, the molecules of the twisted nematic liquid crystal will line up along the lines of this electric field, effectively breaking up the optical circular polarization characteristic of the twisted nematic liquid crystal. As a result, the polarization of only a portion of the light that passes along the Z-dimension through the twisted nematic crystals will be turned 90 degrees. The portion that has not been turned 90 degrees will be blocked by the optical polarizing filter (400), since the orientation of that portion does not line up with the orientation of said filter (400). The net effect is that not all the light will pass through the pixel.

With the just described mechanism it is possible to turn on and off the transparency of an individual pixel, by controlling the voltage of the gate and data line conductors (413 and 414).

The system is best described by the term "two-dimensional matrix of light valves".

### RIP, network and drivers

A raster image processor (RIP) converts a page that is described in a page description language such as "Portable Document Format" (PDF) into a raster bitmap such as for example a TIFF bitmap. The following table shows that for a panel having dimensions equal to 1250 mm by 950 mm in combination with a pixel size of 10 µm and 1 bits per pixel the TIFF image has a size of almost 1.5 GB.

| | |
|---|---|
| Panel width | 1.25 m |
| Panel height | 0.95 m |
| Pixel size | 10E-06 m |
| Nbr of bits per pixel | 1 bit/pixel |
| Nbr of bytes | 1.484E+09 bytes |

The bitmap can be temporarily stored in a computer memory (or on a hard disk) before it is sent to the panel. In order to transfer the bitmap in the example to the panel in a time less than 20 s, a transfer speed is needed of at least 75 MB/s. This transfer speed falls well within the limits of standard serial communication channels such as Ethernet.

On the panel itself resides a demultiplexer which unpacks the stream of incoming bytes into a two-dimensional matrix with digital count values for the pixels.

### Variations

A number of variations exist regarding the panel geometry.

In a first variation, the electrical fields that control the polarization characteristic of the nematic liquid crystal are not oriented along the Z-dimension, but rather along the X or Y-dimensions. In that case electrode (410) in FIG. 4 is replaced by a finger of electrodes alongside the conductors (413, 414).

In a second variation, the orientation of the optical polarization filters (400) and (401), is not perpendicular but parallel. In that case the effect of an electrical field between electrodes on translucency is reversed: the absence of an electrical field now corresponds with low translucency, whereas an electrical field increases the translucency.

In the present invention the thin film field effect transistors (412) are not placed along the electrodes (411) (as in FIG. 6A), but rather in or near the middle of them (as in FIG. 6B). Near the middle means within less than 20% of the size of the electrode (411) from its center. At first it may appear that this creates an undesirable black spot in the middle of the pixel. The inventors, however, have found that this effect is beneficial when the panel is used in the context of using the panel for making a relief printing plate, as it provides a structured pattern in the relief printing plate that improves its ink accepting properties and increases the density of solids.

The invention is defined by the appended claims.

### Industrial applicability

The invention is advantageously used for replacing a conventional mask film in a light box for preparing a print master. The print master can be flexographic print master, but also a traditional offset printing plate. The invented system eliminates separate equipment and process steps to create the conventional film mask. It also eliminates the chemical waste that the creation of a conventional mask film involves as well the waste caused by the mask film itself. Because the invented system involves no moving parts, it is reliable. It can be economically manufactured using standard industrial process that are already available for the manufacturing of LCD displays.

## Claims

1. A digital mask panel suitable for exposing a printing plate precursor (302), the panel comprising a two-dimensional array of pixels of which the transparency can be individually switched between a first level and a second level that is lower than the first level, the ratio of the first over the second level defining a contrast ratio; the panel being **characterized in that**:
- said contrast ratio exceeds 20/1 in the UV-A part of the electromagnetic spectrum; and
- whereby the pixel array pitch is 40 µm or smaller; and
- whereby the pixel array additionally comprises:
- a first linear optical polarizing filter (400) having a first orientation;
- a second linear optical polarizing filter (401) having a second orientation;
- in between said two linear optical polarizing filters (400, 401) liquid crystals (407) having an optical polarization characteristic that can be altered by an electrical field;
- a set of electrodes (411) for each pixel of the array set up to control an electric field within each pixel of the array;
- means (412, 413, 414) for controlling the electric field between the electrodes which comprises a transistor (412) which is located near the middle of the electrodes (411), which means within less than 20 % of the size of the electrode from its centre.

2. The digital mask panel according to claim 1 wherein the liquid cristals are twisted nematic liquid crystals.

3. The digital mask panel according to claim 2 wherein the twisted nematic liquid crystals reside between two polymer layers (404, 405) that are kept at a fixed distance by multiple spacer spheres (406).

4. The digital mask panel according to claim 3 wherein the polymer layers (404, 405) are sandwiched in between two ultra-thin glass plates (402, 403).

5. The digital mask panel according to any of the claims from 1 to 4 wherein the panel further comprises a two-dimensional collimating micro-lens system (420).

6. The digital mask panel according to claim 1 further **characterized in that**:
- it has a width in the range from 850 mm to 1050 mm;
- it has a height in the range from 1150 mm to 1350 mm.

7. The digital mask panel according to any of the claims from 1 to 6 wherein each pixel of the array is square with a size of 40 µm by 40 µm or less.

8. The digital mask panel according to any of the claims from 1 to 6 wherein each pixel of the array is square with a size of 20 µm by 20 µm or less.

9. The digital mask panel according to any of the claims from 1 to 8 wherein the contrast ratio exceeds 100/1 in the UV-A part of the electromagnetic spectrum extending between 315 and 400 nm.

10. The digital mask panel according to any of the claims from 1 to 9 wherein said panel has a one-bit monochrome tonal resolution.

11. The digital mask panel according to any of the claims from 1 to 9 wherein said panel has a tonal resolution of two or three bits.

12. The digital mask panel according to any of the claims from 1 to 11 wherein said panel comprises a demultiplexer which unpacks stream of incoming bytes into the two-dimensional array of pixels with digital count values for the pixels; wherein said unpacked incoming bytes is a raster bitmap of a page, described in a page description language wherein said page is converted to said raster bitmap by a raster image processor.

13. A light box for creating flexographic print masters; wherein said light box comprises a digital mask panel according to any of the claims from 1 to 12.

14. Use of a digital mask panel according to any of the claims from 1 to 12 for creating a flexographic print master.

15. Use of a digital mask panel according to any of the claims from 1 to 12 for creating an offset print master.

## Patentansprüche

1. Ein digitales Maskenpanel, das zur Belichtung einer Druckplattenvorstufe (302) geeignet ist, wobei das Panel eine zweidimensionale Matrix von Pixeln umfasst, deren Transparenz sich individuell zwischen einem ersten Wert und einem zweiten, unter dem ersten Wert liegenden Wert einstellen lässt, wobei das Verhältnis vom ersten Wert zum zweiten Wert ein Kontrastverhältnis definiert,
wobei das Panel **dadurch gekennzeichnet ist, dass**:
- das Kontrastverhältnis über 20/1 im UV-A-Teil des elektromagnetischen Spektrums liegt, und
- wobei der Pixelmatrixpitch bei 40 µm oder weniger liegt, und
- wobei die Pixelmatrix zusätzlich Folgendes umfasst:
- einen ersten linearen optischen Polarisationsfilter (400) mit einer ersten Orientierung,
- einen zweiten linearen optischen Polarisationsfilter (401) mit einer zweiten Orientierung,
- zwischen beiden linearen optischen Polarisationsfiltern (400, 401) Flüssigkristalle (407) mit einer optischen Polarisationskennlinie, die sich mittels eines elektrischen Feldes ändern lässt,
- einen Satz von Elektroden (411) für jedes Pixel der Matrix, der so konfiguriert ist, dass er ein elektrisches Feld innerhalb jedes Pixels der Matrix steuert,
- Mittel (412, 413, 414) zur Steuerung des elektrischen Feldes zwischen den Elektroden, umfassend einen Transistor (412), der sich nahe an der Mitte der Elektroden (411) befindet, d.h. innerhalb weniger als 20% der Größe der Elektrode von deren Mitte.

2. Das digitale Maskenpanel nach Anspruch 1, wobei die Flüssigkristalle verdrillt nematische Flüssigkristalle sind.

3. Das digitale Maskenpanel nach Anspruch 2, wobei die verdrillt nematischen Flüssigkristalle zwischen zwei Polymerschichten (404, 405), die mittels mehrfacher Abstandshalterkugeln (406) an einem festen Abstand gehalten werden, vorliegen.

4. Das digitale Maskenpanel nach Anspruch 3, wobei die Polymerschichten (404, 405) in einer Sandwichstruktur zwischen zwei ultradünnen Glasplatten (402, 403) vorliegen.

5. Das digitale Maskenpanel nach einem der Ansprüche 1 bis 4, wobei das Panel ferner ein zweidimensionales Kollimatormikrolinsensystem (420) umfasst.

6. Das digitale Maskenpanel nach Anspruch 1, das ferner **dadurch gekennzeichnet ist, dass**:
- es eine Breite im Bereich von 850 nm bis 1050 aufweist,
- es eine Höhe im Bereich von 1150 nm bis 1350 nm aufweist.

7. Das digitale Maskenpanel nach einem der Ansprüche 1 bis 6, wobei jedes Pixel der Matrix ein Quadrat mit einer Größe von 40 µm x 40 µm oder weniger ist.

8. Das digitale Maskenpanel nach einem der Ansprüche 1 bis 6, wobei jedes Pixel der Matrix ein Quadrat mit einer Größe von 20 µm x 20 µm oder weniger ist.

9. Das digitale Maskenpanel nach einem der Ansprüche 1 bis 8, wobei das Kontrastverhältnis über 20/1 im sich zwischen 315 und 400 nm erstreckenden UV-A-Teil des elektromagnetischen Spektrums liegt.

10. Das digitale Maskenpanel nach einem der Ansprüche 1 bis 9, wobei die Tonauflösung des Panels ein 1-Bit-monochrom ist.

11. Das digitale Maskenpanel nach einem der Ansprüche 1 bis 9, wobei die Tonauflösung des Panels ein 2-Bit oder 3-Bit ist.

12. Das digitale Maskenpanel nach einem der Ansprüche 1 bis 11, wobei das Panel einen Demultiplexer umfasst, mittels dessen ein Strom eingehender Bytes in die zweidimensionale Pixelmatrix mit digitalen Zählwerten für die Pixel entpackt wird, wobei der Strom entpackter eingehender Bytes ein Rasterbitmap einer in einer Seitenbeschreibungssprache beschriebenen Seite ist, wobei die Seite durch einen Rasterbildprozessor in das Rasterbitmap konvertiert ist.

13. Ein Belichtungskasten zur Herstellung flexografischer Druckmaster, wobei der Belichtungskasten ein digitales Maskenpanel nach einem der Ansprüche 1 bis 12 umfasst.

14. Verwendung eines digitalen Maskenpanels nach einem der Ansprüche 1 bis 12 zur Herstellung eines flexografischen Druckmasters.

15. Verwendung eines digitalen Maskenpanels nach einem der Ansprüche 1 bis 12 zur Herstellung eines Offsetdruckmasters.

## Revendications

1. Panneau de masque digital approprié pour l'exposition d'un précurseur de plaque d'impression (302), ledit panneau comprenant une matrice bidimensionnelle de pixels dont la transparence se laisse régler entre un premier niveau et un deuxième niveau qui est inférieur audit premier niveau, le rapport du premier niveau au deuxième niveau définissant un rapport de contraste,
ledit panneau étant **caractérisé en ce que**:
- ledit rapport de contraste étant supérieur à 20/1 dans la région UV-A du spectre électromagnétique, et
- la distance entre les pixels de la matrice de pixels étant égale ou inférieure à 40 µm, et
- ladite matrice de pixels comprenant en outre:
- un premier filtre de polarisation optique linéaire (400) ayant une première orientation,
- un deuxième filtre de polarisation optique linéaire (401) ayant une deuxième orientation,
- entre lesdits deux filtres de polarisation optiques linéaires (400, 401) des cristaux liquides (407) ayant une caractéristique de polarisation optique qui se laisse modifier à l'aide d'un champ électrique,
- un ensemble d'électrodes (411) pour chaque pixel de la matrice, ledit ensemble étant configuré de façon à contrôler un champ électrique dans chaque pixel de la matrice,
- des moyens (412, 413, 414) servant à contrôler le champ électrique entre les électrodes et comprenant un transistor (412) situé près du centre des électrodes (411), c'est-à-dire à une distance par rapport audit centre qui est inférieure à 20% des dimensions de l'électrode.

2. Panneau de masque digital selon la revendication 1, **caractérisé en ce que** les cristaux liquides sont des cristaux liquides nématiques tordus.

3. Panneau de masque digital selon la revendication 2, **caractérisé en ce que** les cristaux liquides nématiques tordus se trouvent entre deux couches de polymère (404, 405) tenues à une distance fixe par une multitude de billes d'espacement (406).

4. Panneau de masque digital selon la revendication 3, **caractérisé en ce que** les couches de polymère (404, 405) se trouvent en sandwich entre deux panneaux de verre ultraminces (402, 403).

5. Panneau de masque digital selon l'une quelconque des revendications 1 à 4, **caractérisé en ce que** le panneau comprend en outre un système bidimensionnel de microlentilles collimatrices (420).

6. Panneau de masque digital selon la revendication 1, **caractérisé en outre en ce que**:
- ledit panneau présente une largeur comprise entre 850 mm et 1050 mm,
- ledit panneau présente une hauteur comprise entre 1150 mm et 1350 mm.

7. Panneau de masque digital selon l'une quelconque des revendications 1 à 6, **caractérisé en ce que** chaque pixel de la matrice est un carré ayant des dimensions maximales de 40 µm x 40 µm.

8. Panneau de masque digital selon l'une quelconque des revendications 1 à 6, **caractérisé en ce que** chaque pixel de la matrice est un carré ayant des dimensions maximales de 20 µm x 20 µm.

9. Panneau de masque digital selon l'une quelconque des revendications 1 à 8, **caractérisé en ce que** le rapport de contraste est supérieur à 100/1 dans la région UV-A du spectre électromagnétique qui s'étend entre 315 et 400 nm.

10. Panneau de masque digital selon l'une quelconque des revendications 1 à 9, **caractérisé en ce que** la résolution tonale du panneau est monochrome 1 bit.

11. Panneau de masque digital selon l'une quelconque des revendications 1 à 9, **caractérisé en ce que** la résolution tonale du panneau est 2 bits ou 3 bits.

12. Panneau de masque digital selon l'une quelconque des revendications 1 à 11, **caractérisé en ce que** ledit panneau comprend un démultiplexeur décompressant un flux de bits d'entrée en ladite matrice bidimensionnelle de pixels ayant des valeurs de comptage numériques pour les pixels, ledit flux de bits d'entrée décompressés étant un bitmap tramé d'une page décrite dans un langage de description de page, ladite page étant convertie en ce bitmap tramé à l'aide d'un processeur d'image tramée.

13. Caisson d'exposition pour la fabrication de matrices d'impression flexographique, **caractérisé en ce que** ledit caisson d'exposition comprend un panneau de masque digital selon l'une quelconque des revendications 1 à 12.

14. Utilisation d'un panneau de masque digital selon l'une quelconque des revendications 1 à 12 pour la fabrication d'une matrice d'impression flexographique.

15. Utilisation d'un panneau de masque digital selon l'une quelconque des revendications 1 à 12 pour la fabrication d'une matrice d'impression offset.
